# EUROPEAN PATENT APPLICATION

(11) **EP 2 120 093 A1**
(43) Date of publication of application: **18.11.2009**
(21) Application number: 09160038.7
(22) Date of filing: 12.05.2009
(51) Int. Cl.: G03F 1/14

(54) **Pellicle for use in semiconductor lithography**

(30) Priority: 14.05.2008 JP 2008126920
(71) Applicant: Shin-Etsu Chemical Co., Ltd., Tokyo (JP)
(72) Inventor: Shirasaki, Toru, Annaka-Shi Gunma-Ken (JP)
(74) Representative: Peaucelle, Chantal

(57) **Abstract**

A pellicle used in semiconductor lithography is provided and includes a photomask adhesive layer for affixing the pellicle to a photomask. The photomask adhesive layer has a surface layer and a lower layer. The lower layer has one or more sub-layers. A Young's modulus of the surface layer is higher than a Young's modulus of any sub-layer forming the lower layer.

## Description

### Field of the Invention

The present invention relates to a pellicle for use in semiconductor lithography used to protect from dirt when manufacturing a semiconductor device such as an LSI or a ULSI. The pellicle according to the present invention also finds suitable application even in the case where an ultraviolent light of wavelength of 200 nm or less is used to obtain high resolution.

### Background Art

Conventionally, manufacturing of semiconductor devices such as an LSI or a ULSI involves patterning by irradiating a semiconductor wafer with light. However the foregoings have a problem in that when dirt is deposited on a photomask (exposure base plate) used in this case, this dirt absorbs and reflects the light, the transferred pattern is deformed and the edge is roughened, thereby degrading the dimension, quality, and appearance, and as a result, the performance of the semiconductor device or the manufacturing yield is lowered.

Therefore, these tasks are usually performed in a clean room, but it is difficult to keep all the time the photomask in a good condition even inside the clean room, and hence, there is often performed a method of affixing a pellicle that has good transmission to the exposure light on the surface of the photomask to protect from dirt.

In this case, there is an advantage in that the dirt is not deposited directly on the surface of the photomask, but is deposited on the pellicle film, so that during lithography, the dirt on the pellicle exerts no influence on the transfer, provided that the focus is set onto the pattern of the photomask.

The pellicle is formed by a pellicle frame, a pellicle film affixed to an upper portion of the pellicle frame, and an adhesive layer arranged on a lower portion of the pellicle frame. The pellicle film is formed from a raw material such as transparent nitrocellulose or cellulose acetate which allows good light transmission. The pellicle frame is formed from a raw material such as aluminum, stainless steel, or polyethylene. The pellicle film is affixed to the pellicle frame using a method of applying a good solvent of the pellicle film on an upper portion of the pellicle frame, and bonding by drying (see JP-A-S58-219023) or a method of boding with a bonding agent such as an acrylic resin or an epoxy resin (see US Patent No. 4861402, JP-B-S63-27707, and JP-A-H7-168345). The adhesive configuring the adhesive layer includes polybutene resin, polyvinyl acetate resin, acrylic resin, silicone resin, etc. A separator (release layer) generally is affixed in the adhesive layer of the pellicle to protect the adhesive layer.

In the recent years, lithography resolutions are slowly increasing, and therefore, to realize that resolution, light with a shorter wavelength slowly becomes used as a light source. Specifically, the light is ultraviolet light, and there is a shift from g-line (436 nm) to i-line (365 nm) and further to KrF excimer lasers (248 nm), while the use of ArF excimer lasers (193 nm) has recently begun.

### Summary of Invention

### Technical Problem

In a light exposure device for semiconductors, a pattern drawn on a photomask is baked onto a silicon wafer using a short-wavelength light. However, when unevenness is present in the photomask and silicon wafer, a focus deviation is occurred during exposure, and there occurs a problem in the baked pattern. When miniaturization is developed, the planarity required for the photomask and the silicon wafer becomes increasingly rigorous. Therefore, with respect to the planarity required for the photomask, there is once a requirement of flatness of 2 µm on the pattern face, and since that time, the requirement has become slowly rigorous. Subsequent to a 65-nm node, this requirement falls to 0.5 µm or 0.25 µm. It is noted that flatness as used herein refers to an absolute value of a difference in height between the highest position of a surface to be measured above an imaginary plane that is a reference (which is determined by a method of least squares based on the surface to be measured) and the lowest position of the surface to be measured therebelow.

On the other hand, a pellicle is affixed to a photomask to protect a pattern from dirt after the photomask is completed, but affixing the pellicle to the photomask may cause a change in the planarity of the photomask. This is generally thought to be an effect of unevenness of the pellicle frame on the planarity of the photomask.

When the planarity of the photomask is changed, there occurs a problem that the pattern drawn on the photomask is distorted and the pattern transferred onto the silicon wafer during exposure is also distorted, in other words, the positional accuracy of the pattern is deteriorated. Generally, in the semiconductor exposure, a plurality of layers are exposed, and thus, if the positional accuracy of the pattern is deteriorated, there arises a problem that positional alignment for each layer is deviated. Furthermore, since increasingly minute patterns are exposed in recent years, double patterning is under consideration in which a single pattern is divided into two photomasks so that it is exposed twice. In this case, the pattern is distorted, and when the positional accuracy of the pattern is deteriorated, the dimensions of the pattern are directly affected.

The pellicle is affixed to the photomask by a photomask adhesive applied to one side of the pellicle frame, but in the case where the pellicle is affixed to the photomask, usually, the pellicle is attached by pressure to the photomask with a force of about 20 to 30 kg. Although the flatness of a photomask generally is several µm or less, and that of the most advanced photomasks is 1 µm or less, the flatness of the pellicle frame generally is several tens of µm, which is larger as compared to the flatness of the photomask. As a result, when the pellicle is affixed to the photomask, the flatness of the photomask may be changed by the unevenness of the pellicle frame. In this case, it is probable that when the flatness of the pellicle frame is increased to about that of the photomask, the planarity change of the photomask can be reduced.

Pellicle frames generally are made of aluminum alloy. Pellicle frames used in semiconductor lithography have a width of about 150 mm and a length of about 110 to 130 mm, and have a shape with an opening in a central region. Generally, pellicle frames are manufactured by cutting a plate of aluminum alloy into a pellicle frame shape, or extrusion molding of an aluminum material into the pellicle frame shape. However, the pellicle frame has a thin frame shape with a width of about 2 mm, and therefore, is easily deformed; and it is not always easy to make a flat pellicle frame. Therefore, it is difficult to achieve the flatness of the pellicle frame similar to the level of the photomask.

Usually, one face of the pellicle frame is applied with adhesive, and when the adhesive surface of the pellicle frame is pressed against the photomask, the pellicle can be attached to the photomask. Since the Young's modulus of the adhesive layer usually is about 1 MPa, and generally, the Young's modulus of aluminum alloy used for the pellicle frame is about 72 GPa, the adhesive layer is very soft compared to the pellicle frame. It is thus assumed that the adhesive layer absorbs the unevenness of the pellicle frame surface, thereby mitigating the influence of the unevenness exerted onto the photomask. Although the Young's modulus of the adhesive layer usually is about 1 MPa, when an adhesive with a low Young's modulus is used, i.e., when a soft adhesive is used, the unevenness in the pellicle frame can be effectively absorbed.

Recently, it has been discovered that not only distortions in the pellicle frame but also the flatness of the adhesive layer surface affects the planarity change of the photomask. When unevenness is present on the adhesive layer surface and the pellicle is affixed to the photomask, stress is locally generated. Due to the generated local stress, the photomask is deformed. When the adhesive is sufficiently flat, even when the pellicle is affixed to the photomask, the deformation of the adhesive layer is small, and as a result, the stress applied by the pellicle to the photomask is small. Consequently, the deformation of the photomask is small.

Generally, the photomask adhesive is formed on the pellicle frame by the following procedure. A liquid or paste adhesive is applied onto the end surfaces of the pellicle frame. As methods for forming an adhesive in a liquid or paste form, a method of using a solvent to dilute an adhesive prior to cross linking or a method of heating a hot-melt type of adhesive can be adopted, for example. The cross section of the adhesive layer is convex and unevenness is occurred in various locations when the adhesive is just applied onto the frame. Thus, to solve this, the flat plane surface is pressed when the adhesive is still flowing, and in this state, the adhesive is hardened, and then, the flattening processing is performed. The adhesive exhibits rubber elasticity while maintaining a flat surface, and then, a photomask adhesive layer for affixing the pellicle to the photomask is completed.

However, there is a problem that when a relatively soft adhesive is used, the flatness of the flat surface formed by the flattening processing is deteriorated. One reason for this is that soft adhesives tend to change in adhesive shape during hardening of the adhesive. Also, there is another problem that after pressing the adhesive layer onto the flat surface, a stress is applied to the adhesive when peeling the adhesive layer from the flat surface. Consequently, when the adhesive is soft, the level of deformation resulting from the stress is high, and thus, the adhesive deforms during the peeling step.
The present invention is proposed to solve the above problems.

### Solution to Problem

In order to solve the above problems, the present inventor formed a photomask adhesive layer for affixing a pellicle to a photomask by a surface layer and a lower layer being formed of one or more sub-layers. The inventor was able to form a flat surface by making a Young's modulus of the surface layer higher than a Young's modulus of any sub-layer forming the lower layer.
A Young's modulus of the surface layer is preferably 0.2 MPa or more, and more preferably, between 0.2 and 0.5 MPa. When the value is less than 0.2 MPa, there is a tendency that a flat suface is difficult to form. Furthermore, when the value exceeds 0.5 MPa, although good planarity is obtained in the photomask adhesive itself, reproducibility of that shape on the photomask when the photomask adhesive is affixed to the photomask is deteriorated. As a result, there is a tendency that the flatness of the photomask changes.
In the lower layer, the Young's modulus of the sub-layer with the lowest Young's modulus is preferably 0.15 MPa or less. The value may be practically set between 0.04 and 0.15 MPa. When the Young's modulus in the sub-layer with the lowest Young's modulus in the lower layer exceeds 0.15 MPa, the distortion of the pellicle frame tends not to be absorbed. Any sequence of sub-layers having different Young's modulus values may be formed in the lower layer. However, a layer formation in which the Young's modulus of sub-layers in the lower layer increases towards the surface layer is simple and preferred.

As described above, although a relatively soft adhesive absorbs distortion in the pellicle frame, the formation of a flat surface is not facilitated. On the other hand, a relatively hard adhesive facilitates the formation of a flat surface but has a lower effect on the absorption of distortion in the pellicle frame. Thus, a relatively soft adhesive layer is firstly formed as a lower layer on the side nearer to the pellicle frame, and relatively harder adhesive layers are formed thereon as a surface layer in order to flatten the hard adhesive layers. Since the surface is a layer formed from a hard adhesive layer, i.e., a layer which does not tend to deform in response to stress, a good flat surface is obtained by the flattening processing. Since a soft adhesive layer is present as the lower layer, the distortion in the pellicle frame can be effectively absorbed. The lower layer acts as an absorbent layer for distortion in the pellicle frame, and thus, with respect to the thickness, a high thickness is more effective, and with respect to Young's modulus, a lower Young's modulus is more effective.

There is no particular limitation on the number of sub-layers in the lower layer, and thus, a single sub-layer or two or more sub-layers may be provided.

### Advantageous Effects of Invention

According to the present invention, unevenness in the surface of a pellicle frame is absorbed by a lower layer with a low Young's modulus, and furthermore, the surface of an adhesive layer can be flattened by a surface layer with a high Young's modulus. As a result, distorting effects of the pellicle frame on the photomask can be eliminated, and good positional accuracy is obtained. Thus, an exact transfer pattern can be obtained even in the case of ultraviolet light exposure of wavelength of 200 nm or less used for exposure requiring high resolution.

### Description of Embodiments

As an actual procedure of forming an adhesive layer, a single sub-layer or two or more sub-layers in the lower layer are firstly arranged on an end face of the pellicle frame, and the surface of the lower layer is applied with an adhesive in liquid or paste form which on hardening has a higher Young's modulus than any of the adhesives forming the lower layer. Herein, as methods for forming an adhesive in a liquid or paste form, a method of using a solvent to dilute an adhesive prior to cross linking or a method of heating a hot-melt type of adhesive can be adopted, for example. Subsequently, flattening processing is applied while the surface layer is still flowing, and thereafter, the adhesive layer is allowed to harden.
A single sub-layer or two or more sub-layers in the lower layer may be provided by sequentially applying an adhesive in liquid or paste form. The hardening of the lower layer may be performed at each sub-layer formation, in a state where two or more sub-layers are laminated, or simultaneously of hardening of the surface layer. It is preferred that the adhesive for the surface layer is applied in a state where the adhesive in the lower layer is semi-hardened, the flattening processing is performed, and then, the overall adhesive layer is completely hardened.
Although it is not necessary to perform the flattening processing to the lower layer, it is preferred to also perform the flattening processing to the lower layer. The flattening processing performed on the lower layer may be performed at each formation of each sub-layer of the lower layer or at the stage of laminating the overall lower layer.
The above-described procedure enables completion of a photomask adhesive layer with a flattened surface in which the lower layer is a soft adhesive layer and the surface layer is a hard adhesive layer.
It is noted that when the lower layer is thickened, the effect as an absorbent layer is heightened.
Although any type of material can be used as an adhesive, the use of a silicone-based adhesive is preferred.

### Examples

Examples of the present invention will be described below.
The Young's modulus of the adhesive is measured by separately hardening the same adhesive as that applied onto the pellicle frame under the same conditions to obtain an adhesive piece and then subjecting the resultant piece to tension experiments.
Flatness (an absolute value of a difference in height between the highest position of a surface to be measured above an imaginary plane that is a reference (which is determined by a method of least squares based on the surface to be measured) and the lowest position of the surface to be measured therebelow) is measured using an optical interferometer.

Changes in the flatness of the photomask before and after affixing the pellicle as measured in the Examples and Comparative Examples are shown in Table 1 and Table 2.

### Example 1

A pellicle frame made of aluminum alloy (outer dimensions of 149 mm x 115 mm x 4.5mm, with a thickness of 2 mm; having a flatness of 30 µm on the adhesive side) was cleaned in purified water, after which a silicone adhesive (a mixture of 1:1 (weight ratio) of KE76SR and X-40-3264L, Young's modulus after hardening: 0.1 MPa) made by Shin-Etsu Chemical Co., Ltd. was applied onto an end face thereof. Thereafter, the adhesive layer was placed downward, and an adhesive layer was pressed onto a 50-µm-thick PET separator placed on a quartz substrate to mold an adhesive layer. After allowing to stand for three hours, the separator was peeled from the adhesive layer. At this time, the thickness of the adhesive layer was 0.5 mm.

A silicone adhesive (X-40-3264, Young's modulus after hardening: 0.3 MPa) made by Shin-Etsu Chemical Co., Ltd. was applied onto the molded adhesive layer (first sub-layer in the lower layer). Thereafter, the adhesive layer was placed downward, and the adhesive layer was pressed onto a 50-µm-thick PET separator placed on a quartz substrate to mold an adhesive layer. After allowing to stand for three hours, the separator was peeled from the adhesive layer. At this time, the thickness of the adhesive layer was 0.8 mm.

A bonding agent Cytop (CTX-A) made by Asahi Glass Co., Ltd. was applied onto the opposite end face of the pellicle frame. Thereafter, the pellicle frame was heated at 130°C to harden the adhesive and bonding agent. After hardending, the flatness of the adhesive layer surface was measured at 10 µm. Thereafter, the bonding agent side of the pellicle frame was affixed to a pellicle film retained in a larger aluminum frame than the pellicle frame, and the pellicle was completed by removing portions outside of the pellicle frame.

When the pellicle was affixed to a photomask having a flatness of 0.15 µm, the flatness of the photomask stayed at a change to 0.17 µm which was a good result. It is noted that the measurement of the flatness of the photomask after affixing was performed in a peripheral portion of the affixed pellicle.

### Example 2

A pellicle frame made of aluminum alloy (outer dimensions of 149 mm x 115 mm x 4.5 mm, with a thickness of 2 mm; having a flatness of 30 µm on the adhesive side) was cleaned in purified water, after which a silicone adhesive (a mixture of 2:1 (weight ratio) of KE76SR and X-40-3264L, Young's modulus after hardening: 0.05 MPa) made by Shin-Etsu Chemical Co., Ltd. was applied to an end face thereof. Thereafter, the adhesive layer was placed downward, and an adhesive layer was pressed onto a 50-µm-thick PET separator placed on a quartz substrate to mold an adhesive layer. After allowing to stand for three hours, the separator was peeled from the adhesive layer. At this time, the thickness of the adhesive layer was 0.5 mm.

A silicone adhesive (X-40-3264, Young's modulus after hardening: 0.3 MPa) made by Shin-Etsu Chemical Co., Ltd. was applied onto the molded adhesive layer (first sub-layer in the lower layer). Thereafter, the adhesive layer was placed downward, and the adhesive layer was pressed onto a 50-µm-thick PET separator placed on a quartz substrate to mold an adhesive layer. After allowing to stand for three hours, the separator was peeled from the adhesive layer. At this time, the thickness of the adhesive layer was 0.8 mm.

A bonding agent Cytop (CTX-A) made by Asahi Glass Co., Ltd. was applied onto the opposite end face of the pellicle frame. Thereafter, the pellicle frame was heated at 130°C to harden the adhesive and bonding agent. After hardending, the flatness of the adhesive layer surface was measured at 10 µm. Thereafter, the bonding agent side of the pellicle frame was affixed to a pellicle film retained in a larger aluminum frame than the pellicle frame, and the pellicle was completed by removing portions outside of the pellicle frame.

When this pellicle was affixed to a photomask having a flatness of 0.15 µm, the flatness of the photomask stayed at a change to 0.16 µm which was an extremely good result.

### Example 3

A pellicle frame made of aluminum alloy (outer dimensions of 149 mm x 115 mm x 4.5 mm, with a thickness of 2 mm; having a flatness of 30 µm on the adhesive side) was cleaned in purified water, after which a silicone adhesive (a mixture of 1:1 (weight ratio) of KE76SR and X-40-3264L, Young's modulus after hardening: 0.1 MPa) made by Shin-Etsu Chemical Co., Ltd. was applied onto an end face thereof. Thereafter, the adhesive layer was placed downward, and an adhesive layer was pressed onto a 50-µm-thick PET separator placed on a quartz substrate to mold an adhesive layer. After allowing to stand for three hours, the separator was peeled from the adhesive layer. At this time, the thickness of the adhesive layer was 0.8 mm.

A silicone adhesive (X-40-3264, Young's modulus after hardening: 0.3 MPa) made by Shin-Etsu Chemical Co., Ltd. was applied onto the molded adhesive layer (first sub-layer in the lower layer). Thereafter, the adhesive layer was placed downward, and the adhesive layer was pressed onto a 50-µm-thick PET separator placed on a quartz substrate to mold an adhesive layer. After allowing to stand for three hours, the separator was peeled from the adhesive layer. At this time, the thickness of the adhesive layer was 1.1 mm.

A bonding agent Cytop (CTX-A) made by Asahi Glass Co., Ltd. was applied onto the opposite end face of the pellicle frame. Thereafter, the pellicle frame was heated at 130°C to harden the adhesive and bonding agent. After hardending, the flatness of the adhesive layer surface was measured at 10 µm. Thereafter, the bonding agent side of the pellicle frame was affixed to a pellicle film retained in a larger aluminum frame than the pellicle frame, and the pellicle was completed by removing portions outside of the pellicle frame.

When the pellicle was affixed to a photomask having a flatness of 0.15 µm, the flatness of the photomask stayed at a change to 0.16 µm which was an extremely good result.

### Example 4

A pellicle frame made of aluminum alloy (outer dimensions of 149 mm x 115 mm x 4.5 mm, with a thickness of 2 mm; having a flatness of 30 µm on the adhesive side) was cleaned in purified water, after which a silicone adhesive (a mixture of 2:1 (weight ratio) of KE76SR and X-40-3264L, Young's modulus after hardening: 0.05 MPa) made by Shin-Etsu Chemical Co., Ltd. was applied onto an end face thereof. Thereafter, the adhesive layer was placed downward, and an adhesive layer was pressed onto a 50-µm-thick PET separator placed on a quartz substrate to mold an adhesive layer. After allowing to stand for three hours, the separator was peeled from the adhesive layer. At this time, the thickness of the adhesive layer was 0.3 mm.

A silicone adhesive (a mixture of 1:1 (weight ratio) of KE76SR and X-40-3264L, Young's modulus after hardening: 0.1 MPa) made by Shin-Etsu Chemical Co., Ltd. was applied onto the molded adhesive layer (first sub-layer in the lower layer). Thereafter the adhesive layer was placed downward, and the adhesive layer was pressed onto a 50-µm-thick PET separator placed on a quartz substrate to mold an adhesive layer. After allowing to stand for three hours, the separator was peeled from the adhesive layer. At this time, the thickness of the adhesive layer was 0.5 mm.

Furthermore, a silicone adhesive (X-40-3264, Young's modulus after hardening: 0.3 MPa) made by Shin-Etsu Chemical Co., Ltd. was applied onto the molded adhesive layer (second sub-layer in the lower layer). Thereafter, the adhesive layer was placed downward, and the adhesive layer was pressed onto a 50-µm-thick PET separator placed on a quartz substrate to mold an adhesive layer. After allowing to stand for three hours, the separator was peeled from the adhesive layer. At this time, the thickness of the adhesive layer was 0.8 mm.

A bonding agent Cytop (CTX-A) made by Asahi Glass Co., Ltd. was applied onto the opposite end face of the pellicle frame. Thereafter, the pellicle frame was heated at 130°C to harden the adhesive and bonding agent. After hardending, the flatness of the adhesive layer surface was measured at 10 µm.
Thereafter, the bonding agent side of the pellicle frame was affixed to a pellicle film retained in a larger aluminum frame than the pellicle frame above, and the pellicle was completed by removing portions outside of the pellicle frame.

When the pellicle was affixed to a photomask having a flatness of 0.15 µm, the flatness of the photomask stayed at a change to 0.16 µm which was an extremely good result.

### Example 5

A pellicle frame made of aluminum alloy (outer dimensions of 149 mm x 115 mm x 4.5 mm, with a thickness of 2 mm; having a flatness of 30 µm on the adhesive side) was cleaned in purified water, after which a silicone adhesive (a mixture of 1:1 (weight ratio) of KE76SR and X-40-3264L, Young's modulus after hardening: 0.1 MPa) made by Shin-Etsu Chemical Co., Ltd. was applied onto an end face thereof. Thereafter, the adhesive layer was placed downward, and an adhesive layer was pressed onto a 50-µm-thick PET separator placed on a quartz substrate to mold an adhesive layer. After allowing to stand for three hours, the separator was peeled from the adhesive layer. At this time, the thickness of the adhesive layer was 0.5 mm.

A silicone adhesive (X-40-3264A, Young's modulus after hardening: 0.4 MPa) made by Shin-Etsu Chemical Co., Ltd. was applied onto the molded adhesive layer (first sub-layer in the lower layer). Thereafter, the adhesive layer was placed downward, and the adhesive layer was pressed onto a 50-µm-thick PET separator placed on a quartz substrate to mold an adhesive layer. After allowing to stand for three hours, the separator was peeled from the adhesive layer. At this time, the thickness of the adhesive layer was 0.8 mm.

A bonding agent Cytop (CTX-A) made by Asahi Glass Co., Ltd. was applied onto the opposite end face of the pellicle frame. Thereafter, the pellicle frame was heated at 130°C to harden the adhesive and bonding agent. After hardending, the flatness of the adhesive layer surface was measured at 10 µm. Thereafter, the bonding agent side of the pellicle frame was affixed to a pellicle film retained in a larger aluminum frame than the pellicle frame above, and the pellicle was completed by removing portions outside of the pellicle frame.

When the pellicle was affixed to a photomask having a flatness of 0.15 µm, the flatness of the photomask stayed at a change to 0.17 µm which was a good result.

### Comparative Example 1

A pellicle frame made of aluminum alloy (outer dimensions of 149 mm x 115 mm x 4.5 mm, with a thickness of 2 mm; having a flatness of 30 µm on the adhesive side) was cleaned in purified water, after which a silicone adhesive (a mixture of 1:1 of KE76SR and X-40-3264L, Young's modulus after hardening: 0.1 MPa) made by Shin-Etsu Chemical Co., Ltd. was applied to an end face thereof. Thereafter, the adhesive layer was placed downward, and an adhesive layer was pressed onto a 50-µm-thick PET separator placed on a quartz substrate to mold an adhesive layer. After allowing to stand for three hours, the separator was peeled from the adhesive layer. At this time, the thickness of the adhesive layer was 0.8 mm.

A bonding agent Cytop (CTX-A) made by Asahi Glass Co., Ltd. was applied onto the opposite end face of the pellicle frame. Thereafter, the pellicle frame was heated at 130°C to harden the adhesive and bonding agent. After hardending, the flatness of the adhesive layer surface was measured at 30 µm. Thereafter, the bonding agent side of the pellicle frame was affixed to a pellicle film retained in a larger aluminum frame than the pellicle frame above, and the pellicle was completed by removing portions outside of the pellicle frame.

When the pellicle was affixed to a photomask having a flatness of 0.15 µm, the flatness of the photomask was changed to 0.20 µm.

### Comparative Example 2

A pellicle frame made of aluminum alloy (outer dimensions of 149 mm x 115 mm x 4.5 mm, with a thickness of 2 mm; having a flatness of 30 µm on the adhesive side) was cleaned in purified water, after which a silicone adhesive (X-40-3264, Young's modulus after hardening: 0.3 MPa) made by Shin-Etsu Chemical Co., Ltd. was applied to an end face thereof. Thereafter, the adhesive layer was placed downward, and an adhesive layer was pressed onto a 50-µm-thick PET separator placed on a quartz substrate to mold an adhesive layer. After allowing to stand for three hours, the separator was peeled from the adhesive layer. At this time, the thickness of the adhesive layer was 0.8 mm.

A bonding agent Cytop (CTX-A) made by Asahi Glass Co., Ltd. was applied onto the opposite end face of the pellicle frame. Thereafter, the pellicle frame was heated at 130°C to harden the adhesive and bonding agent. After hardending, the flatness of the adhesive layer surface was measured at 10 µm. Thereafter, the bonding agent side of the pellicle frame was affixed to a pellicle film retained in a larger aluminum frame than the pellicle frame above, and the pellicle was completed by removing portions outside of the pellicle frame.

When the pellicle was affixed to a photomask having a flatness of 0.15 µm, the flatness of the photomask was changed to 0.21 µm.

**[Table 1]**

| | | Example 1 | Example 2 | Example 3 | Example 4 | Example 5 |
|---|---|---|---|---|---|---|
| modulus of adhesive layer (MPa) | first sub-layer | 0.1 | 0.05 | 0.1 | 0.05 | 0.1 |
| | second sub-layer | - | - | - | 0.1 | - |
| | surface layer | 0.3 | 0.3 | 0.3 | 0.3 | 0.4 |
| thickness of adhesive layer (mm) | first sub-layer | 0.5 | 0.5 | 0.8 | 0.3 | 0.5 |
| | second sub-layer | - | - | - | 0.2 | - |
| | surface layer | 0.3 | 0.3 | 0.3 | 0.3 | 0.3 |
| flatness of adhesive layer surface (µm) | | 10 | 10 | 10 | 10 | 10 |
| flatness of photomask (µm) | before affixing | 0.15 | 0.15 | 0.15 | 0.15 | 0.15 |
| | after affixing | 0.17 | 0.16 | 0.16 | 0.16 | 0.17 |

**[Table 2]**

| | | Comparative Example 1 | Comparative Example 2 |
|---|---|---|---|
| modulus of adhesive layer (MPa) | first sub-layer | - | - |
| | second sub-layer | - | - |
| | surface layer | 0.1 | 0.3 |
| thickness of adhesive layer (mm) | first sub-layer | - | - |
| | second sub-layer | - | - |
| | surface layer | 0.8 | 0.8 |
| flatness of adhesive layer surface (µm) | | 30 | 10 |
| flatness of photomask (µm) | before affixing | 0.15 | 0.15 |
| | after affixing | 0.20 | 0.21 |

## Claims

1. A pellicle used in semiconductor lithography, comprising a photomask adhesive layer for affixing the pellicle to a photomask, wherein
the photomask adhesive layer comprises a surface layer and a lower layer, the lower layer being formed of one or more sub-layers, and
a Young's modulus of the surface layer is higher than a Young's modulus of any sub-layer forming the lower layer.

2. The pellicle according to claim 1, wherein the Young's modulus of the surface layer is 0.2 MPa or more, and a Young's modulus of the sub-layer in the lower layer having the lowest Young's modulus is 0.15 MPa or less.

3. The pellicle according to claim 1 or 2, wherein the Young's modulus of the surface layer is between 0.2 and 0.5 MPa, and the Young's modulus of the sub-layer in the lower layer having the lowest Young's modulus is between 0.04 and 0.15 MPa.

4. The pellicle according to any one of claims 1 to 3, wherein the lower layer comprises two sub-layers or more, and the Young's modulus of the sub-layers in the lower layer increases towards the surface layer.
